# EUROPÄISCHE PATENTSCHRIFT

(11) **EP 2 943 988 B1**
(45) Veröffentlichungstag und Bekanntmachung des Hinweises auf die Patenterteilung: **09.08.2017**
(21) Anmeldenummer: 14702198.4
(22) Anmeldetag: 10.01.2014
(51) Int. Cl.: H01L 41/083, H01L 41/27, H01L 41/293

(54) **VERFAHREN UND VORRICHTUNG ZUM HERSTELLEN EINES MULTILAGENELEKTRODENSYSTEMS**
METHOD AND DEVICE FOR PRODUCING A MULTI-LAYER ELECTRODE SYSTEM
PROCÉDÉ ET DISPOSITIF DE FABRICATION D'UN SYSTÈME D'ÉLECTRODE MULTICOUCHE

(30) Priorität: 14.01.2013 DE 102013200354
(43) Veröffentlichungstag der Anmeldung: 18.11.2015
(73) Patentinhaber: Robert Bosch GmbH, 70442 Stuttgart (DE)
(72) Erfinder: PIRK, Tjalf, 70195 Stuttgart (DE); KRAUSS, Andreas, 72072 Tuebingen (DE); HEUCK, Friedjof, 70197 Stuttgart (DE); LEIDICH, Stefan, 71272 Renningen (DE); SCHELLING, Christoph, 70597 Stuttgart (DE)
(86) Internationale Anmeldenummer: PCT/EP2014/050372
(87) Internationale Veröffentlichungsnummer: WO 2014/108499

(56) Entgegenhaltungen:
- US-A- 5 691 594
- US-B1- 6 289 564

## Beschreibung

### Stand der Technik

Die vorliegende Erfindung bezieht sich auf ein Multilagenelektrodensystem und ein Verfahren zum Herstellen eines Multilagenelektrodensystems, auf eine entsprechende Vorrichtung sowie auf ein entsprechendes Computerprogrammprodukt.

Piezoelektrische Materialien haben die besondere Eigenschaft, dass sie sich bei angelegtem elektrischen Feld entweder ausdehnen oder zusammenziehen, bzw. als inverser Effekt, dass sich ein elektrisches Feld ausbildet, sobald das Material gedehnt oder gestaucht wird. In der Aktorik werden piezoelektrische Materialien eingesetzt, um hochpräzise Positionierer zu entwickeln. Beispielsweise kann ein PZT-Aktor verwendet werden, um ein Gyroskop zu betreiben. Piezoelektrische Materialien bieten eine elegante Möglichkeit für einen Sensor, kleinste Längenänderungen direkt in ein elektrisches Signal umzuwandeln. Schlussendlich finden piezoelektrische Materialien verbreiteten Einsatz in Mikro-Energy-Harvestern. Hierbei werden hauptsächlich Beschleunigungen in Form von Vibrationen in elektrische Energie überführt.

Heutzutage gibt es zwei verschiedene Ansätze, piezoelektrische Elemente in Multilagen herzustellen. In einem ersten Verfahren werden piezoelektrische Multilagen in Dickschichttechnik erzeugt. Die Multilagen werden hierbei so ausgelegt, dass jeweils eine Lage piezoelektrischen Materials zwischen je zwei Lagen Elektroden liegt. Da der piezoelektrische Effekt vom elektrischen Feld abhängt, kann die notwendige angelegte elektrische Spannung durch die Anzahl der einzelnen Lagen dividiert werden. Dabei wird die Spannung so angelegt, dass die eine Hälfte der Elektrodenlagen, d. h. jede zweite Elektrodenlage gegen die andere Hälfte geschaltet wird. Die Kontaktierung der Elektroden zu einem Multilagenbauteil geschieht hierbei über eine Dickschichtstrukturierung während der Elektrodenabscheidung und einer Metallisierung an der Seitenfläche des Multilagenbauteils. Die in der Dickschicht erreichbaren dünnsten Lagen liegen bei ungefähr 20 µm, wobei das PZT in der Dickschichttechnik eine Durchbruchfeldstärke von ca. 2 V/µm hat. Dies bedeutet, dass Spannungen von rund 40 V notwendig sind, um mit Feldstärken nahe dem Durchbruch zu arbeiten, wo die größten mechanischen Stellwege resultierten.

Die in der Mikrosystemtechnik verwendete Dünnschichttechnik erlaubt meistens nur die Verwendung einer Monolage mit nur einer piezoelektrischen Lage. Für die Abscheidung des piezoelektrischen Materials gibt es zwei verschiedene Verfahren, zum einen das Sol-Gel basierte Aufbringen oder zum anderen die Abscheidung im Vakuum. Die hierbei erzeugten Schichtdicken liegen bei wenigen 100 nm bis hin zu 10 µm. Durch die höhere Qualität der Dünnschichten liegen die Durchbruchfeldstärken bei ca. 10 V/µm. Von daher reichen Spannungen von bis zu 10 V bei einer Schichtdicke von 1 µm aus, um an der Grenze zum Durchbruch zu arbeiten. Gerade die Abscheidung im Vakuum hat den Vorteil, dass in einer Maschine in einem Prozess alternierend Elektrodenmaterial und piezoelektrisches Material abgeschieden werden kann und damit Multilagen erzeugt werden können.

Ein bekannter Ansatz zum elektrischen Kontaktieren besteht darin, die individuellen Elektroden alternierend zu kontaktieren. Hierbei wird jede Elektrode individuell justiert photolithographisch strukturiert. Für eine technisch sinnvolle Umsetzung kann mit diesem Verfahren eine Multilage mit bis zu fünf Schichten hergestellt werden.

Eine weitere Möglichkeit bietet eine verfahrbare Schattenmaske. Hierbei wird bei der Abscheidung der Elektrode im Vakuum eine Hartmaske über das Substrat gefahren, und die Elektrode wird nur an offenen Bereichen der Maske abgeschieden. Für die anschließende piezoelektrische Abscheidung wird die Maske wieder entfernt und bei der Abscheidung der nächsten Elektrode positionsversetzt wieder eingesetzt.

Die US 2011/0294015 A1 beschreibt ein Verfahren zum Herstellen einer Dünnfilmbatterie. Dabei werden unmaskiert ein erstes Elektrodenmaterial, ein Batteriematerial und ein zweites Elektrodenmaterial nacheinander wiederholt auf eine Trägerstruktur abgeschieden, um eine Dünnfilmbatterie mit einer Mehrzahl von ersten Elektrodenschichten, Batterieschichten und zweiten Elektrodenschichten zu bilden.

In US 6289564 B1 ist ein piezoelektrischer Mikroaktuator gezeigt. Ein Substrat weist eine Vertiefung mit schrägen Wänden auf. In der Vertiefung sind eine erste Elektrode, eine piezoelektrische Schicht und eine zweite Elektrode angeordnet. Dieser Schichtstapel erstreckt sich über die Vertiefung mit den schrägen Wänden und einen Teil der Oberfläche des Substrats.

### Offenbarung der Erfindung

Vor diesem Hintergrund wird mit der vorliegenden Erfindung ein Verfahren zum Herstellen eines Multilagenelektrodensystems, weiterhin eine Vorrichtung, die dieses Verfahren verwendet, sowie schließlich ein entsprechendes Computerprogrammprodukt gemäß den Hauptansprüchen vorgestellt. Vorteilhafte Ausgestaltungen ergeben sich aus den jeweiligen Unteransprüchen und der nachfolgenden Beschreibung.

Ein Verfahren zum Herstellen eines Multilagenelektrodensystems verwendet ein Trägersubstrat, bei dem zumindest eine Wand einer Vertiefung zum Aufnehmen eines Multilagenstapels geneigt ausgebildet ist. So kann es auf einfache Weise ermöglicht werden, die Elektroden planar von oben einzeln zu kontaktieren.

Gemäß dem hier vorgeschlagenen Konzept kann eine Kontaktierungsmethode geschaffen werden, mit der eine alternierende Multilagenelektrodenstruktur in Dünnschichttechnologie dargestellt werden kann. Auch kann für diese ein kostengünstiges Verfahren bereitgestellt werden, das lediglich eine geringe Anzahl an Lithographieschritten und keine Unterbrechung oder Modifikation in der Vakuumabscheidung erfordert. Ein derartiges Verfahren weist den Vorteil auf, dass es relativ insensitiv zur Anzahl der zu kontaktierenden Multilagen ist, d. h., es ist auf viele Lagen skalierbar. Damit bietet das hier vorgestellte Verfahren eine Möglichkeit zur mikrosystemtechnischen Kontaktierung von alternierenden Multilagenelektrodensystemen wie z. B. piezoelektrischen Multilagen für MEMS-Aktoren.

Ein Verfahren gemäß dem hier vorgeschlagenen Konzept kann schnell und kostengünstig durchgeführt werden, da es beispielsweise nicht mehr erforderlich ist, für jede einzelne Strukturierung der Elektroden das Vakuum unterbrechen zu müssen, sodass die Gefahr einer Oxidationsverunreinigung der Oberfläche, die auf das weitere kristalline Schichtwachstum Einfluss nehmen könnte, gebannt werden kann. Des Weiteren können die bei einem Einsatz herkömmlicher Verfahren möglichen Abscheideraten von ca. 200 nm/min und möglichen PZT-Schichtdicken von 100 nm bei Weitem übertroffen werden. Zudem kann auch die Prozesszeit dadurch extrem verkürzt werden, dass der Zeitaufwand zum Wiederherstellen des Vakuums entfallen kann. Zeitliche und Kostenvorteile ergeben sich bei dem hier vorgestellten Ansatz auch gegenüber einem Verfahren, bei dem der gesamte Schichtstapel abgeschieden und anschließend jede Elektroden- bzw. PZT-Lage individuell strukturiert wird. Denn mit dem hier vorgestellten Verfahren ist die Anzahl der Lithographieschritte nicht länger an die Anzahl der Lagen gekoppelt. Es kann ohne großen Aufwand eine Multilage mit fünf oder mehr Schichten hergestellt werden. Zudem ermöglicht das hier vorgestellte Konzept eine gute Strukturübertragung und damit eine hohe Auflösung.

Es wird ein Verfahren zum Herstellen eines Multilagenelektrodensystems vorgestellt, wobei das Verfahren die folgenden Schritte aufweist:
Bereitstellen eines Trägersubstrats mit einer Vertiefung in einer Oberseite des Trägersubstrats, wobei zumindest eine Wand der Vertiefung in Bezug auf eine der Oberseite gegenüberliegende Unterseite des Trägersubstrats geneigt ausgebildet ist; und
Aufbringen eines Multilagenstapels, der zumindest eine erste Elektrodenlage, eine zweite Elektrodenlage und eine zwischen der ersten Elektrodenlage und der zweiten Elektrodenlage angeordnete Piezoelektrikumlage aufweist, auf die Oberseite des Trägersubstrats, wobei zumindest die Wand und ein Boden der Vertiefung durch zumindest einen Abschnitt des Multilagenstapels abgedeckt werden, um das Multilagenelektrodensystem zu bilden.

Das Verfahren kann maschinell und computerisiert unter Aufrechterhaltung eines Vakuums von einer geeigneten Vorrichtung durchgeführt werden, beispielsweise unter Verwendung eines geeigneten Computerprogrammprodukts. Die Schritte des Bereitstellens und des Aufbringens können in geeigneten Einrichtungen der Vorrichtung durchgeführt werden. Bei dem Multilagenelektrodensystem kann es sich beispielsweise um einen Aktor für ein Mikrosystem bzw. MEMS-System (Micro-Electro-Mechanical System) handeln. Alternativ kann es sich bei dem Multilagenelektrodensystem auch um einen Sensor oder Generator handeln. Bei dem Trägersubstrat kann es sich um eine balkenförmige oder flache zylindrische Struktur handeln, die ausgebildet sein kann, um den Multilagenstapel zu tragen und dem Multilagenelektrodensystem eine allgemeine Form und Handhabungsmöglichkeit zu verleihen. Das Trägersubstrat kann beispielsweise aus Silizium bestehen. Die Vertiefung kann - z. B. in einem geeigneten Schritt des Verfahrens - durch eine Form des strukturierten Ätzens einer Oberfläche des Trägersubstrats an der Oberseite hergestellt worden sein. Bei der Oberseite des Trägersubstrats kann es sich um eine Hauptseite des Trägersubstrats, also eine Seite mit einer gegenüber quer zu derselben verlaufenden Seiten des Trägersubstrats größeren Fläche handeln. Die der Oberseite gegenüberliegende Unterseite des Trägersubstrats kann parallel oder annähernd parallel zu der Oberseite ausgebildet sein. Die Oberseite und die Unterseite des Trägersubstrats können als ebene Flächen ausgebildet sein. Bei einem quaderförmigen Trägersubstrat kann es sich bei der Wand der Vertiefung um eine von insgesamt vier Wänden handeln, die alle dieselbe Neigung in Bezug auf den Boden der Vertiefung aufweisen können. Ist das Trägersubstrat zylinderförmig ausgebildet, kann die Wand eine Form eines eine gesamte Wandfläche der Vertiefung bildenden Trichters aufweisen. Unabhängig von einer Formgestaltung der Vertiefung kann diese so ausgebildet sein, dass ihre Öffnung in dem Trägersubstrat stets größer als ihr Boden ist, die Vertiefung als also stets eine Trichterform aufweist. Der Boden der Vertiefung kann parallel oder annähernd parallel zu der Unterseite des Trägersubstrats verlaufen. Ein Verkippungswinkel zwischen der zumindest einen geneigten Wand und dem Boden der Vertiefung bzw. der Unterseite des Trägersubstrats zwischen einem und 90 Grad betragen. Insbesondere kann der Verkippungswinkel 45 Grad oder annähernd 45 Grad betragen. Die erste Elektrodenlage, die zweite Elektrodenlage und die Piezoelektrikumlage können als sehr dünne aufeinandergelegte Schichten oder Folien ausgebildet werden. So können die erste Elektrodenlage und die zweite Elektrodenlage z. B. eine Dicke im Bereich von 100 nm aufweisen und die Piezoelektrikumlage z. B. eine Dicke im Bereich von 500 nm bis 1 µm aufweisen. Die einzelnen Schichten des Multilagenstapels können z. B. durch einen Prozess des Abscheidens auf die Oberfläche des Trägersubstrats aufgebracht werden. Beispielsweise kann die erste Elektrodenlage als eine Kathode und die zweite Elektrodenlage als eine Anode ausgebildet werden, um an die zwischen ihnen angeordnete Piezoelektrikumlage eine elektrische Spannung anzulegen oder aus einer Verformung der Piezoelektrikumlage eine elektrische Spannung zu gewinnen. Die erste und die zweite Elektrodenlage können aus einem geeigneten Metall gebildet werden, während die Piezoelektrikumlage aus einem Material gebildet werden kann, das geeignet ist, um - basierend auf dem Piezo-Effekt - sich bei Anlegen einer elektrischen Spannung zu verformen oder aufgrund einer Verformung eine elektrische Spannung zu generieren. Die erste Elektrodenlage, die zweite Elektrodenlage und die Piezoelektrikumlage können - in Abhängigkeit von einer Form des Trägersubstrats - z. B. rechteck- oder kreisförmig ausgebildet werden. Der Multilagenstapel kann so ausgebildet werden, dass eine Haupterstreckung der ersten Elektrodenlage, der zweiten Elektrodenlage und der Piezoelektrikumlage parallel zu einer Haupterstreckung der Unterseite des Trägersubstrats bzw. des Bodens der Vertiefung ausgerichtet ist. Der Multilagenstapel kann auch aus einer Mehrzahl von ersten Elektrodenlagen, zweiten Elektrodenlagen und Piezoelektrikumlagen gebildet werden, wobei die schlussendliche Anordnung im Stapel stets so ist, dass eine Piezoelektrikumlage zwischen einer ersten Elektrodenlage und einer zweiten Elektrodenlage angeordnet ist.

Erfindungsgemäß wird in dem Schritt des Aufbringens der Multilagenstapel ferner auf einen an die Vertiefung angrenzenden Randbereich dieser Oberseite des Trägersubstrats aufgebracht. Der Schritt des Aufbringens kann insbesondere einen Teilschritt des Abtragens des Multilagenstapels bis auf ein Niveau der Oberseite des Trägersubstrats aufweisen, um eine mit der Oberseite plane Kontaktierungsfläche zum elektrischen Kontaktieren der ersten Elektrode und der zweiten Elektrode zu bilden. Dabei kann insbesondere eine Seitenfläche der ersten Elektrodenlage einen Anschlussbereich für einen ersten Kontakt bereitstellen und eine Seitenfläche der zweiten Elektrodenlage einen Anschlussbereich für einen zweiten Kontakt bereitstellen. Der angrenzende Randbereich kann dabei so ausgeformt sein, dass er die Vertiefung ringartig umgibt. Beispielsweise kann der Multilagenstapel so auf die Oberseite des Trägersubstrats aufgebracht werden, dass er die gesamte Vertiefung sowie den gesamten Randbereich abdeckt. Der Teilschritt des Abtragens kann beispielsweise durch geeignetes Rückschleifen des auf dem Randbereich aufliegenden Abschnitts des Multilagenstapels erfolgen. In der Folge des Abtragens kann der Multilagenstapel so ausgebildet sein, dass die erste und zweite Elektrodenlage sowie die Piezoelektrikumlage aufgrund ihrer gewinkelten Auflage auf der geneigten Wand der Vertiefung schräg angeschnitten sind. Die mit der Oberseite plane Kontaktierungsfläche kann parallel zu der Unterseite des Trägersubstrats bzw. dem Boden der Vertiefung verlaufen. Die Elektrodenseitenflächen der ersten Elektrodenlage und der zweiten Elektrodenlage können senkrecht oder quer zu der Haupterstreckung der ersten und zweiten Elektrodenlage verlaufen. Die Elektrodenseitenflächen der ersten Elektrodenlage und der zweiten Elektrodenlage können jeweils einen ringförmigen Anschlussbereich für den ersten bzw. zweiten Kontakt bereitstellen. Der erste und zweite Kontakt können ausgebildet sein, um das Multilagenelektrodensystem elektrisch zu kontaktieren.

Gemäß einer weiteren Ausführungsform kann das Verfahren einen Schritt des Passivierens des Multilagenstapels aufweisen. Dabei kann in einem ersten Teilschritt des Passivierens eine Passivierungsschicht auf das Multilagenelektrodensystem aufgebracht werden und in einem zweiten Teilschritt des Passivierens ein Bereich der Passivierungsschicht so entfernt werden, dass zumindest eine in einem vorteilhaft spitzen Winkel zu der Seitenfläche der ersten Elektrodenlage und der Seitenfläche der zweiten Elektrodenlage verlaufende Kontaktbahn gebildet wird, die durch Freilegen eines Abschnitts des Anschlussbereichs für einen ersten Kontakt eine erste Kontaktfläche bilden kann und durch Freilegen eines Abschnitts des Anschlussbereichs für einen zweiten Kontakt eine zweite Kontaktfläche bilden kann. Die zweite Kontaktfläche kann dabei insbesondere versetzt zu der ersten Kontaktfläche angeordnet werden. Die Passivierungsschicht kann dabei ausgebildet sein, um das Multilagenelektrodensystem mit einer galvanischen Isolierung zu versehen, sodass es zu keinen unerwünschten elektrischen Kurzschlüssen kommen kann. Die Passivierungsschicht kann wie die Lagen des Multilagenstapels durch Abscheiden aufgebracht werden. Die Passivierungsschicht kann so aufgebracht werden, dass sie die gesamte Oberseite des Trägersubstrats mit dem darauf angeordneten Multilagenstapel abdeckt. Der spitze Winkel, in dem die Kontaktbahn bezüglich den Elektrodenelektrodenseitenflächen der ersten und zweiten Elektrodenlage vorteilhaft gebildet wird, kann beispielsweise 45 Grad betragen. Als eine Folge des Schrägverlaufs der Kontaktbahn bezüglich der Elektrodenseitenflächen der ersten und zweiten Elektrodenlage können die erste Kontaktfläche und die zweite Kontaktfläche eine Form eines Parallelogramms aufweisen. Mit der durch diese Ausprägung der Kontaktbahn erzielbaren versetzten Anordnung der ersten und zweiten Kontaktfläche kann vorteilhafterweise erreicht werden, dass die erste und zweite Kontaktfläche weiter voneinander beabstandet sind, als dies der Fall wäre, wenn die Kontaktbahn senkrecht zu den Elektrodenseitenflächen der ersten und zweiten Elektrodenlage angelegt würde. Die elektrische Kontaktierung der Elektrodenlagen kann damit einfach und störungsfreier erfolgen.

Insbesondere kann in dem Schritt des Passivierens die Kontaktbahn so gebildet werden, dass sie sich unter einem spitzen Winkel zu dem Multilagenstapel erstreckt. Beispielsweise kann sich die Kontaktbahn zwischen einer Ecke der Kontaktierungsfläche und einer der Ecke diagonal gegenüberliegenden weiteren Ecke der Kontaktierungsfläche erstrecken. Diese Ausführungsform bietet den Vorteil, dass sämtliche Elektrodenlagen eines Multilagenstapels durch die Kontaktbahn zur elektrischen Kontaktierung freigelegt werden können.

Ferner kann in dem Schritt des Passivierens zumindest eine weitere innerhalb eines Toleranzbereichs parallel zu der Kontaktbahn verlaufende Kontaktbahn gebildet werden. Dieser Toleranzbereich kann beispielsweise eine Abweichung von 20 Grad von einer exakten parallelen Ausrichtung der Kontaktbahn und der weiteren Kontaktbahn umfassen. So kann vorteilhafterweise eine Möglichkeit geschaffen werden, die erste Elektrodenlage und die zweite Elektrodenlage mit zusätzlichen Kontakten zu kontaktieren, sodass ein Übergang eines elektrischen Stromes zwischen den Elektroden und einer außerhalb des Multilagenelektrodensystems angeordneten Stromquelle besonders sicher und robust ausgelegt werden kann. Bei dieser Ausführungsform des Verfahrens können die erste Kontaktfläche und die zweite Kontaktfläche so gebildet werden, dass sie sich aus entsprechenden, von der Passivierungsschicht unterbrochenen, jeweiligen Teilkontaktflächen zusammensetzen. Die jeweiligen Teilkontaktflächen können dabei eine identische Form aufweisen. Diese Ausführungsform ermöglicht eine Herstellung eines Multilagenelektrodensystems mit redundanter Kontaktierung. Sollte ein Kontakt ausfallen, kann seine Funktion von einem oder mehreren weiteren Kontakten übernommen werden.

Gemäß einer weiteren Ausführungsform kann das Verfahren einen Schritt des elektrisch leitfähigen Kontaktierens aufweisen, in dem ein erster Kontakt quer zu der Kontaktbahn so auf das Multilagenelektrodensystem aufgesetzt wird, dass er die erste Kontaktfläche elektrisch kontaktiert und ein zweiter Kontakt quer zu der Kontaktbahn so auf das Multilagenelektrodensystem aufgesetzt wird, dass er die zweite Kontaktfläche elektrisch kontaktiert. Der erste Kontakt und der zweite Kontakt können parallel zueinander auf das Multilagenelektrodensystem aufgesetzt werden. Aufgrund des schrägen Verlaufs der Kontaktbahn können sie ausreichend weit voneinander angeordnet werden, um die elektrische Trennung der beiden Elektroden des Multilagenelektrodensystems voneinander zu gewährleisten.

Insbesondere können in dem Schritt des elektrischen Kontaktierens der erste Kontakt und der zweite Kontakt innerhalb eines Toleranzbereichs senkrecht zu der Kontaktbahn auf das Multilagenelektrodensystem aufgesetzt werden. Dieser Toleranzbereich kann beispielsweise derart gewählt werden, dass er einen Bereich von 20 Grad Abweichung einer exakt senkrechten Ausrichtung des ersten Kontakts und des zweiten Kontakts zu der Kontaktbahn aufweist. So kann auf einfache Weise ein maximaler Abstand zwischen dem ersten und dem zweiten Kontakt des Multilagenelektrodensystems gewährleistet werden. Auch können die Kontakte ohne Weiteres breit genug ausgelegt werden, um die gesamte Fläche der ersten und zweiten Kontaktfläche erreichen zu können.

Gemäß einer weiteren Ausführungsform des Verfahrens können in dem Schritt des elektrischen Kontaktierens zumindest ein weiterer erster Kontakt und zumindest ein weiterer zweiter Kontakt auf das Multilagenelektrodensystem so aufgesetzt werden, dass der weitere erste Kontakt die erste Kontaktfläche elektrisch kontaktiert und der weitere zweite Kontakt die zweite Kontaktfläche elektrisch kontaktiert. Beispielsweise können dabei der erste Kontakt und der zweite Kontakt jeweils stabförmig ausgebildet sein, sodass sie sich über die Kontaktierungsfläche hinweg erstrecken und eine Mehrzahl von Elektrodenlagen kontaktieren können, falls der Multilagenstapel eine solche Mehrzahl von Elektrodenlagen aufweist. Damit kann vorteilhafterweise eine robuste und redundante elektrische Kontaktierung des Multilagenelektrodensystems gewährleistet werden.

Beispielsweise kann das Verfahren ferner einen Schritt des Bildens der Vertiefung in der Oberseite des Trägersubstrats aufweisen, insbesondere wobei die Vertiefung durch ein strukturiertes Ätzen der Oberseite des Trägersubstrats gebildet werden kann. Bei dem strukturierten Ätzen kann es sich z. B. um nasschemisches Siliziumätzen oder DRIE-Trenchen (DRIE; Deep Reactive Ion Etching = Reaktives Ionentiefenätzen) handeln. Der Prozessschritt des strukturierten Ätzens weist den Vorteil auf, dass er einfach und kostengünstig eingesetzt werden kann.

Eine Vorrichtung zum Herstellen eines Multilagenelektrodensystems weist folgende Merkmale auf:
eine Einrichtung zum Bereitstellen eines Trägersubstrats mit einer Vertiefung in einer Oberseite des Trägersubstrats, wobei zumindest eine Wand der Vertiefung gegenüber einer der Oberseite gegenüberliegenden Unterseite des Trägersubstrats geneigt ausgebildet ist; und
eine Einrichtung zum Aufbringen eines Multilagenstapels, der zumindest eine erste Elektrodenlage, eine zweite Elektrodenlage und eine zwischen der ersten Elektrodenlage und der zweiten Elektrodenlage angeordnete Piezoelektrikumlage aufweist, auf die Oberseite des Trägersubstrats, wobei die Einrichtung ausgebildet ist, um zumindest die Wand und einen Boden der Vertiefung durch zumindest einen Abschnitt des Multilagenstapels abzudecken, um das Multilagenelektrodensystem zu bilden. Des Weiteren weist die Vorrichtung zum Herstellen eines Multilagenelektrodensystems folgende Merkmale auf:
   eine Einrichtung zum Abtragen des Multilagenstapels, der beim Aufbringen der Multilagenstapel ferner auf einen an die Vertiefung angrenzenden Randbereich der Oberseite des Trägersubstrats aufgebracht wird, bis auf ein Niveau der Oberseite des Trägersubstrats, um eine mit der Oberseite plane Kontaktierungsfläche zum elektrischen Kontaktieren der ersten Elektrodenlage und der zweiten Elektrodenlage zu bilden, insbesondere wobei eine Seitenfläche der ersten Elektrodenlage einen Anschlussbereich für einen ersten Kontakt bereitstellt und eine Seitenfläche der zweiten Elektrodenlage einen Anschlussbereich für einen zweiten Kontakt bereitstellt.

Die Vorrichtung kann ausgebildet sein, um die Schritte einer Variante des hier vorgestellten Verfahrens in den entsprechenden Einrichtungen durchzuführen bzw. umzusetzen. Auch durch diese Ausführungsvariante der Erfindung in Form einer Vorrichtung kann die der Erfindung zugrunde liegende Aufgabe schnell und effizient gelöst werden.

Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert sein kann und zur Durchführung oder Ansteuerung von Schritten des Verfahrens nach einer der vorstehend beschriebenen Ausführungsformen verwendet wird, wenn das Programmprodukt auf einem Computer oder einer Vorrichtung ausgeführt wird.

Die Erfindung wird nachstehend anhand der beigefügten Zeichnungen beispielhaft näher erläutert. Es zeigen:
- Fig. 1: eine Aufsicht auf ein Trägersubstrat gemäß einem Ausführungsbeispiel der vorliegenden Erfindung;
- Fig. 2: eine Seitenansicht eines Ausschnitts aus dem Trägersubstrat aus Fig. 1;
- Fig. 3: eine Querschnittsansicht eines Abschnitts eines Multilagenelektrodensystems gemäß einem Ausführungsbeispiel der vorliegenden Erfindung;
- Fig. 4: eine Querschnittsansicht des Abschnitts des Multilagenelektrodensystems aus Fig. 3 nach Abtragen eines Bereichs des Multilagenstapels, gemäß einem Ausführungsbeispiel der vorliegenden Erfindung;
- Fig. 5: eine Aufsicht auf den Abschnitt des Multilagenelektrodensystems aus Fig. 4;
- Fig. 6: eine Querschnittsansicht des Multilagenelektrodensystems mit Kontakten, gemäß einem Ausführungsbeispiel der vorliegenden Erfindung;
- Fig. 7: eine Aufsicht auf eine Passivierungsschicht des Multilagenelektrodensystems, gemäß einem Ausführungsbeispiel der vorliegenden Erfindung;
- Fig. 8: eine Aufsicht auf eine Kontaktierung des Multilagenelektrodensystems, gemäß einem Ausführungsbeispiel der vorliegenden Erfindung; und
- Fig. 9: ein Ablaufdiagramm eines Verfahrens zum Herstellen eines Multilagenelektrodensystems, gemäß einem Ausführungsbeispiel der vorliegenden Erfindung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

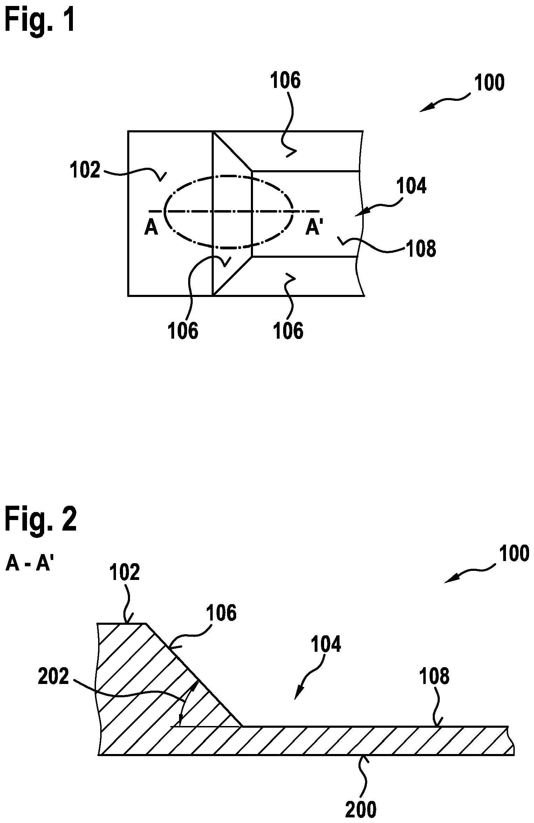

Fig. 1 zeigt in einer Aufsicht einen Abschnitt eines Ausführungsbeispiels eines Trägersubstrats 100 für ein Multilagenelektrodensystem. Das Trägersubstrat 100 ist hier aus Silizium gebildet. Eine Oberseite 102 des Trägersubstrats 100 weist eine Vertiefung 104 mit einer ersten, zweiten und dritten Wand 106 sowie einem Boden 108 auf. Die Vertiefung 104 wurde durch strukturiertes Ätzen, hier KOH-Ätzen, gebildet. Alternativ können zur Bildung der Vertiefung 104 auch andere Verfahren des nasschemischen Silizium-Ätzens, z. B. TMAH- oder isotropes Si-Ätzen, oder auch der Prozess des DRIE-Trenchätzens eingesetzt werden. Wie die Darstellung in Fig. 1 zeigt, ist die erste, zweite und dritte Wand 106 der Vertiefung 104 geneigt ausgebildet. Auch eine in Fig. 1 nicht gezeigte vierte Wand der Vertiefung 104 ist bei dem hier gezeigten Ausführungsbeispiel des Trägersubstrats 100 geneigt ausgebildet. Hier ist die Neigung aller Wände 106 gleich. Sie kann sich bei anderen Ausführungsbeispielen auch unterscheiden. Wie die Darstellung in Fig. 1 zeigt, weisen bei dem hier gezeigten Ausführungsbeispiel sowohl das Trägersubstrat 100 als auch die Vertiefung 104 eine rechteckige Form auf. Alternativ sind auch runde Formen des Trägersubstrats 100 und/oder der Vertiefung 104 möglich.

Fig. 2 zeigt in einer Seitenansicht einen Ausschnitt aus dem Trägersubstrat 100 aus Fig. 1 entlang einer Linie A-A'. Die Illustration zeigt gut die Form der Vertiefung 104. So zeigt sich, dass der Boden 108 der Vertiefung 104 parallel zu der Oberseite 102 sowie zu einer zu der Oberseite 102 parallelen Unterseite 200 des Trägersubstrats 100 verläuft. Insbesondere ist hier die Neigung der Wände 106 gut zu erkennen. Wie die Darstellung zeigt, ist die geneigte Wand 106 in einem Verkippungswinkel 202 mit der Unterseite 200 des Trägersubstrats 100 angeordnet. Der Verkippungswinkel bzw. Kantenwinkel 202 ist so ausgelegt, dass er eine zuverlässige Beschichtung aller Flächen 106, 108 der Vertiefung 104 mit den Materialien der Zielstruktur eines zu bildenden Multilagenelektrodensystems erlaubt. Geeignet ist hier insbesondere ein spitzer Winkel. Bei dem in den Figuren 1 und 2 gezeigten Ausführungsbeispiel des Trägersubstrats 100 beträgt der Verkippungswinkel 202 etwa 45 Grad.

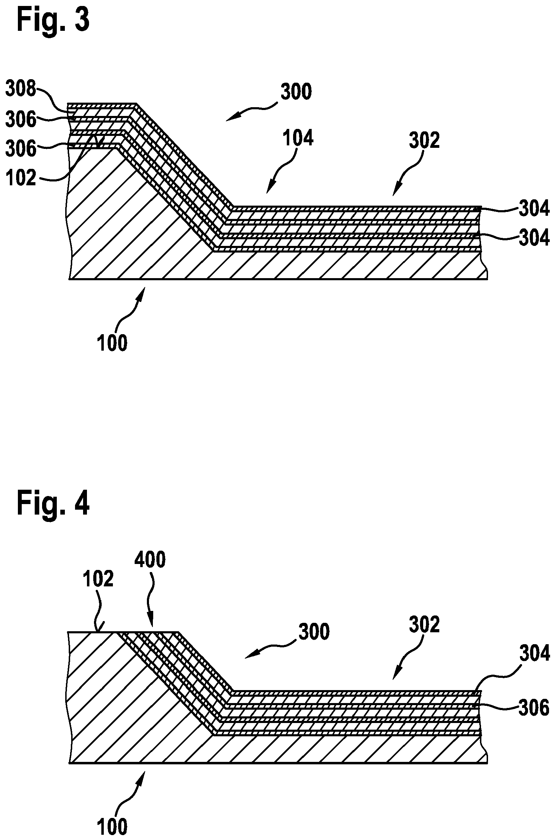

Fig. 3 zeigt in einer weiteren Querschnittsansicht den Abschnitt des Trägersubstrats 100 aus Fig. 2. Zur Bildung eines Ausführungsbeispiels eines Multilagenelektrodensystems 300 ist ein Schichtstapel bzw. Multilagenstapel 302 auf dem Trägersubstrat 100 angeordnet. Der Multilagenstapel 302 umfasst eine erste Elektrodenlage 304, eine zweite Elektrodenlage 306, eine weitere erste Elektrodenlage 304 und eine weitere zweite Elektrodenlage 306. Zwischen den einzelnen Elektrodenlagen 304, 306 ist jeweils sandwichartig eine Piezoelektrikumlage 308 angeordnet. Wie die Darstellung in Fig. 3 zeigt, bedeckt der Multilagenstapel 302 gleichmäßig und ohne Bildung eines Hohlraumes die gesamte Vertiefung 104 sowie auch den an die Vertiefung angrenzenden Randbereich der Oberseite 102 des Trägersubstrats 100. Die Elektroden bzw. Elektrodenlagen 304 und 306 und das Piezoelektrikum bzw. die Piezoelektrikumlagen 308 wurden in einem Schritt eines Herstellungsverfahrens des Multilagenelektrodensystems 300 alternierend abgeschieden. Bei dem in Fig. 3 gezeigten Ausführungsbeispiel des Multilagenelektrodensystems 300 handelt es sich bei dem Piezoelektrikum 308 um PZT (Blei-Zirkonat-Titanat), es können aber auch andere Materialien mit piezoelektrischen Eigenschaften verwendet werden. Um die piezoelektrischen Multilagen 308 nahe der Durchbruchfeldstärke mit möglichst niedrigen Spannungen zu betreiben, werden Schichtdicken des Piezoelektrikums 308 im Bereich von 500 nm bis 1 µm favorisiert, für andere Anwendungen werden die Schichtdicken entsprechend angepasst. Die Elektroden 304, 306 wiederum sollen möglichst geringen Einfluss auf die mechanischen Eigenschaften des Schichtstapels 302 haben und werden, solange es elektrisch möglich ist, sehr dünn, im Bereich von 100 nm, gehalten. Dadurch ergibt sich ein Schichtaufbau 302, wie er am Querschnitt in Fig. 3 gezeigt ist.

Fig. 4 zeigt wiederum in einer Querschnittsansicht den Abschnitt des Multilagenelektrodensystems 300 aus Fig. 3 nach einem Schritt des Abtragens eines Bereichs des Multilagenstapels 302. Wie die Darstellung in Fig. 4 zeigt, werden durch ein geeignetes Rückschleifen in dem Schritt des Abtragens, wie z.B. mittels CMP (Chemical Mechanical Polishing), bis auf das Niveau der Substratoberfläche 102 die ersten Elektroden 304 und zweiten Elektroden 306 von oben zugänglich und können kontaktiert werden. Wie die Darstellung in Fig. 4 zeigt, ist der Multilagenstapel 302 nun schräg angeschnitten und bildet so eine ebene Kontaktierungsfläche 400 zum Anschluss elektrischer Kontakte an das Multilagenelektrodensystem 300.

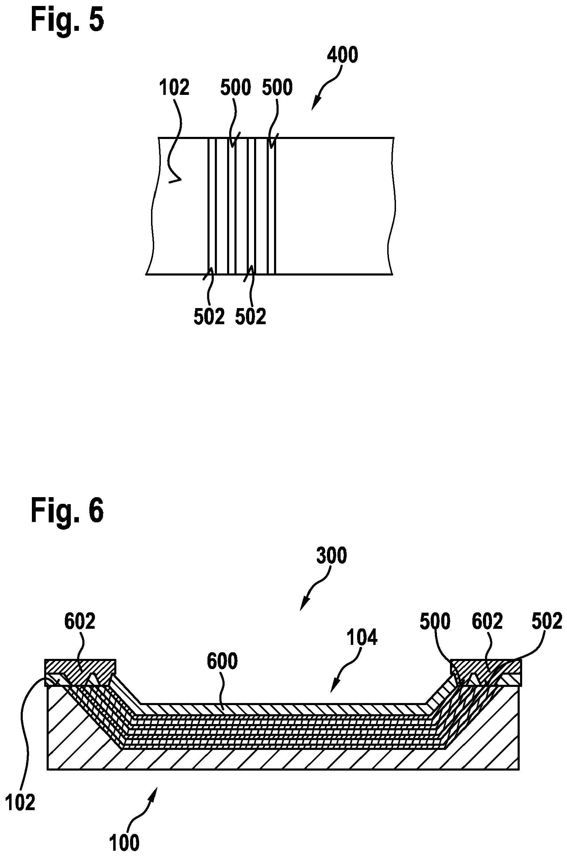

Fig. 5 zeigt in einer Aufsicht die Kontaktierungsfläche 400 des Multilagenelektrodensystems. In dieser Perspektive ist besonders gut zu erkennen, dass infolge des Schrittes des Abtragens jeweils eine Seitenfläche 500 der ersten und der weiteren ersten Elektrodenlage sowie jeweils eine Seitenfläche 502 der zweiten und der weiteren zweiten Elektrodenlage zum Anschluss eines elektrischen Kontakts zugänglich sind. Zu diesem Zeitpunkt im Herstellungsverfahren des Multilagenelektrodensystems 300 erfolgt lediglich noch eine Abscheidung einer elektrisch isolierenden Passivierung und ein Strukturierung derselben sowie eine Kontaktierung der Elektroden 304, 306 über Kontaktlochöffnungen. Darauf wird anhand der nachfolgenden Figuren noch genauer eingegangen.

Fig. 6 zeigt anhand einer weiteren Querschnittsansicht das gesamte Ausführungsbeispiel des Multilagenelektrodensystems 300 einschließlich einer Kontaktierung. Somit zeigt die Darstellung in Fig. 6 das Multilagenelektrodensystem 300 nach der Fertigstellung. Infolge eines Schrittes des Passivierens und eines Schrittes des elektrischen Kontaktierens ist das Multilagenelektrodensystem 300 nun mit einer Passivierungsschicht 600 versehen. Die Passivierungsschicht 600 deckt die gesamte Oberseite 102 des Trägersubstrats 100 einschließlich der Vertiefung 104 ab und ist an geeigneten Stellen geöffnet, um die Elektrodenseitenflächen 500, 502 der Elektrodenlagen für eine Kontaktierung durch Kontakte 602 zugänglich zu machen.

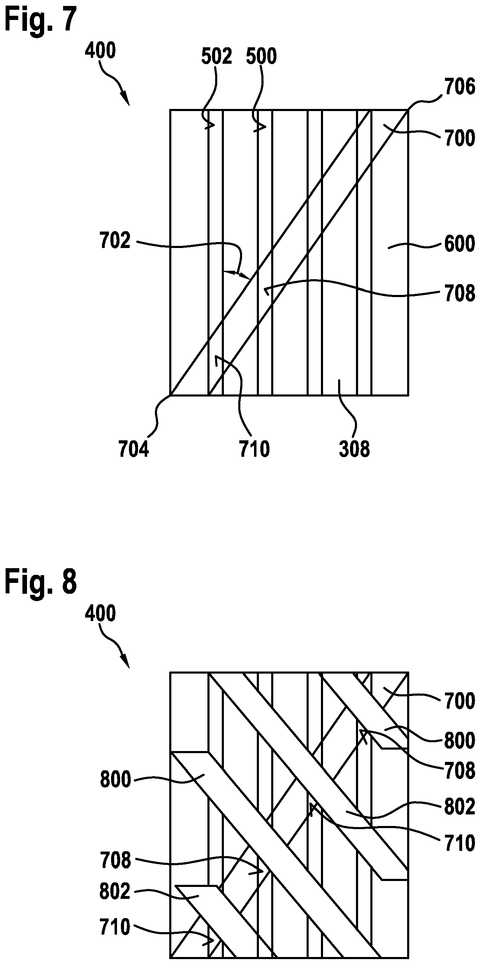

Anhand der nachfolgenden Figuren 7 und 8 werden die Schritte des Passivierens und elektrischen Kontaktierens des Multilagenelektrodensystems 300 anhand von Darstellungen zu den Ergebnissen der Prozessschritte anschaulich erläutert.

Fig. 7 zeigt in einer Aufsicht den Abschnitt des Multilagenelektrodensystems 300 aus Fig. 4 mit der darauf angeordneten und strukturierten Passivierungsschicht 600, gemäß einem Ausführungsbeispiel der vorliegenden Erfindung. Wie die Darstellung in Fig. 7 zeigt, weist das Multilagenelektrodensystem 300 nach dem Prozessschritt des Strukturierens eine Kontaktbahn 700 auf, die in einem spitzen Winkel 702 zu den Elektrodenseitenflächen 500 und den Elektrodenseitenflächen 502 verläuft. Die als verkippte Öffnung durch Entfernen der Passivierungsschicht 600 gebildete Kontaktbahn 700 verläuft bei dem in Fig. 7 gezeigten Ausführungsbeispiel des Multilagenelektrodensystems 300 von einer Ecke 704 der Kontaktierungsfläche 400 zu einer diagonal gegenüberliegenden weiteren Ecke 706. Die die Kontaktbahn 700 bildende Passivierungsöffnung schafft erste Kontaktflächen 708 zum Kontaktieren der ersten Elektrodenseitenflächen 500 mit einem ersten Kontakt und zweite Kontaktflächen 710 zum Kontaktieren der zweiten Elektrodenseitenflächen 502 mit einem zweiten Kontakt. Ein alternatives Ausführungsbeispiel des Multilagenelektrodensystems 300 kann weitere Kontaktbahnen aufweisen, die beispielsweise parallel zu der Kontaktbahn 700 verlaufen können.

Prinzipiell ist es herausfordernd, die exakte Position der Elektroden über den Wafer bzw. die Trägerstruktur verteilt vorauszusagen. Dies wird erschwert zum einen durch die bevorzugt geringen Abstände der Elektroden bzw. Elektrodenlagen von ca. 1 µm und zum anderen deren geringe Breite von ca. 100 nm. Die exakten Dimensionen sind abhängig vom Verkippungswinkel der Seitenwand bzw. Wand der Vertiefung im Trägersubstrat und der geometrisch resultierenden Dicke der abgeschiedenen Schichten des Multilagenstapels aufgrund der Verkippung. Des Weiteren variiert die Position der Elektroden aufgrund von Schwankungen in der Strukturierung bzw. Unterätzung der Vertiefung; zudem ist durch Justageversatz der einzelnen Masken bei der Abscheidung eine Toleranz in der Positionierung der Passivierungsöffnung bzw. Passivierungsöffnungen 700 sowie in den aufgebrachten Kontaktstrukturen zu erwarten. Um bei diesen geringen Abständen den Justageversatz und die Prozesstoleranzen aufzufangen, wird nach dem Aufbringen der elektrischen Passivierung 600 diese vorteilhaft unter einem Winkel 702 zu den Elektroden geöffnet, wie es die Darstellung in Fig. 7 anschaulich zeigt.

Fig. 8 zeigt wiederum in einer Aufsicht die Kontaktierungsfläche 400 des Multilagenelektrodensystems aus Fig. 7 nach einem Schritt des elektrischen Kontaktierens im Herstellungsverfahren des Multilagenelektrodensystems. Hier sind erste Kontakte 800 auf die ersten Kontaktflächen 708 aufgesetzt und zweite Kontakte 802 auf die zweiten Kontaktflächen 710 aufgesetzt. Wie aus der Darstellung in Fig. 8 gut ersichtlich ist, sind die ersten Kontakte 800 und zweiten Kontakte 802 in diesem Beispielfall jeweils senkrecht zu der Kontaktbahn 700 angeordnet. Wie die Darstellung in Fig. 8 zeigt, sind die ersten Kontakte 800 und zweiten Kontakte 802 jeweils als Kontaktierungsbahnen ausgeführt. Mit dem vorteilhaft senkrechten Verlauf der Kontakte 800, 802 zu der Passivierungsöffnung bzw. Kontaktbahn 700 wird abhängig vom Winkel der Abstand zwischen den Kontakten 800, 802 vergrößert. Damit ist das Multilagenelektrodensystem mit geringeren Fabrikationstoleranzen kontaktierbar. Darüber hinaus kann die Anzahl der Kontaktierungsbahnen bzw. Kontakte 800, 802 größer als die Anzahl der Elektroden gewählt werden und damit das Fabrikationstoleranzenfenster erweitert werden. Die Kontaktierungsbahnen 800, 802 ohne Kontakt zu einer individuellen Elektrode sind funktionslos und nicht störend.

Zusammenfassend erläutern die Figuren 1 bis 4 die Strukturierung des Schichtstapels bzw. Multilagenstapels 302 wobei die Figuren 1 und 2 das Ergebnis der Strukturierung des Substrats 100 zur Herstellung einer verkippten Ebene 106 zeigen und die Figuren 3 und 4 das Ergebnis der der alternierenden Abscheidung von Elektrodenmaterial 304, 306 und Piezomaterial (z. B. PZT) 308 für den Schichtstapel 302 und des Rückschleifens und damit Schaffung des horizontalen Zugangs zu den individuellen Elektroden 306, 306 zeigen.

Die Figuren 5 bis 8 erläutern die Kontaktierung der Elektroden 304, 306 in dem piezoelektrischen Schichtstapel 302 nach vorhergegangener Strukturierung durch Abscheiden der elektrisch isolierenden Passivierungsschicht 600 und Strukturierung derselben durch Öffnen von Kontaktlöchern 708, 710 unter dem Winkel 702 zu den Elektroden 304, 306 sowie Abscheidung und Strukturierung der elektrischen Kontaktierungsbahnen 800, 802. Nach Aufbringen und Strukturieren der Kontaktmetallisierung verlaufen die Bahnen 800, 802 vorteilhaft senkrecht zur Öffnung 700 der Passivierung 600; dadurch werden die Abstände zwischen den Kontaktierungsbahnen 800, 802 im Vergleich zu den Elektrodenabständen vergrößert. Zur Erhöhung der elektrischen Anbindungssicherheit können auch mehrere Passivierungsöffnungen 700 parallel zueinander strukturiert werden. Hierbei ist jedoch auf den richtigen Abstand und Winkel 702 der Verdrehung zu achten, damit eine Kontaktbahn 800, 802 nur die Elektroden 304, 306 einer Kontaktierungsseite kontaktiert.

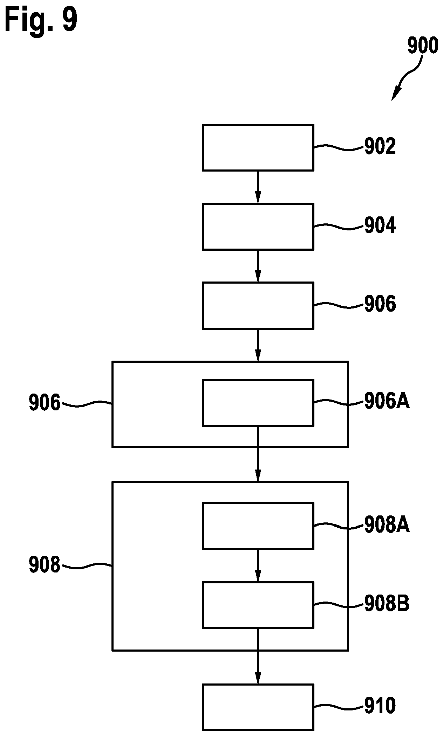

Fig. 9 zeigt ein Ausführungsbeispiel eines Ablaufdiagramms eines Verfahrens 900 zum Herstellen eines Multilagenelektrodensystems gemäß einem Ausführungsbeispiel der vorliegenden Erfindung. In einem Schritt 902 wird mittels strukturierten Ätzens eine Vertiefung in einer Oberseite eines Trägersubstrats für das Multilagenelektrodensystem angelegt, wobei die Vertiefung so ausgeformt wird, dass zumindest eine Wand der Vertiefung in Bezug auf eine Unterseite des Trägersubstrats geneigt ausgebildet ist. In einem Schritt 904 wird das Trägersubstrat zur weiteren Verarbeitung bereitgestellt, sodass in einem folgenden Schritt 906 ein Multilagenstapel auf die Oberseite des Trägersubstrats aufgebracht werden kann. Der Schritt des Aufbringens 906 umfasst einen Teilschritt des Abtragens 906A des Multilagenstapels zur Bildung einer Kontaktierungsfläche zum elektrischen Kontaktieren zumindest einer ersten Elektrode und zumindest einer zweiten Elektrode des Multilagenstapels. Grundsätzlich werden die in dem Schritt 906 planar nach- bzw. aufeinander abgeschiedenen Schichten aus Elektrode, Piezoelektrikum, Elektrode, Piezoelektrikum usw. durch die geeignete vorstrukturierte Vertiefung im Substrat vom horizontalen Verlauf abgelenkt. In dem anschließenden Schritt 906A wird bis auf das Niveau der ursprünglichen Substratoberfläche zurückgeschliffen bzw. das überstehende Material mit anderen geeigneten Verfahren entfernt. Dadurch ist es dann möglich, planar von oben einen Zugang zu den einzelnen Elektroden zu bekommen. In einem Schritt 908 wird der Multilagenstapel strukturiert. Der Schritt 908 umfasst einen Teilschritt 908A des Abscheidens einer elektrisch isolierenden Passivierungsschicht auf das Multilagenelektrodensystem und einen Teilschritt 908B des Entfernens eines Bereichs der Passivierungsschicht zur Bildung zumindest einer Kontaktbahn mit Kontaktlochöffnungen zum Kontaktieren der Elektroden. Die Kontaktbahn wird dabei bevorzugt unter einem ersten flachen Winkel zur Kante der ursprünglichen Substratoberfläche geschaffen. In einem Schritt 910 wird das Multilagenelektrodensystem elektrisch kontaktiert, indem zumindest ein erster Kontakt quer zu der Kontaktbahn so auf das Multilagenelektrodensystem aufgesetzt wird, dass er eine erste Kontaktfläche der ersten Elektrode elektrisch kontaktiert und zumindest ein zweiter Kontakt quer zu der Kontaktbahn so auf das Multilagenelektrodensystem aufgesetzt wird, dass er eine zweite Kontaktfläche der zweiten Elektrode elektrisch kontaktiert.

Ein mit dem Verfahren 900 der mikrosystemtechnischen Elektrodenkontaktierung von piezoelektrischen Multilagen gefertigtes Multilagenelektrodensystem umfasst einen Aufbau, bestehend aus der Vertiefung in dem Substrat, in der sich der Multilagenstapel befindet, der über die Seitenwände bis auf das umgebende Substratniveau hinauf reicht - wobei die geschichteten Lagen des Multilagenstapels angeschnitten sind -, einer darüber befindlichen Isolationsschicht mit Kontaktöffnungen, die bevorzugt unter einem ersten flachen Winkel zur Kante der Vertiefung verlaufen, und Kontaktzuleitungen unter einem zweiten Winkel dazu.

Die Figuren 1 bis 9 erläutern einen Aufbau bzw. ein effektives Verfahren zur Kontaktierung von piezoelektrischen Dünnschichtstapeln. Das Prinzip lässt sich jedoch leicht auf andere Anwendungen, die vorteilhaft mit mehrlagig vertikal geschichteten Interdigitalelektroden realisiert werden können, wie z. B. Dünnschichtbatteriestapel oder Gassensoren, übertragen. Besonders ist hierbei, dass das Verfahren relativ insensitiv zur Anzahl der zu kontaktierenden Multilagen ist, d. h., es ist einfach auf viele Lagen skalierbar.

Mit dem hierin vorgestellten Ansatz kann der Herausforderung erfolgreich begegnet werden, die in der Dünnschichttechnik die Kontaktierung einzelner Elektroden, um einen Multilagenaktor bzw. -sensor aufzubauen, mit sich bringt. Mit dem hier vorgestellten Ansatz kann es gelingen, einen piezoelektrischen Multilagenaktor mit niedriger Antriebsspannung zu entwickeln, dessen Herstellprozess mit MEMS-Prozessen kompatibel ist, und der somit eine ernsthafte Konkurrenz zu dem bisher einzigen etablierten und voll integrierten elektrostatischen MEMS-Aktor darstellen kann.

Das vorgeschlagene Konzept kann in die Entwicklung z. B. von MEMS-Energy-Harvestern oder die Kontaktierung von piezoelektrischen Membranen und Biegebalkensensoren bzw. -aktoren Eingang finden. Weitere Anwendungsgebiete finden sich in der Serienschaltung von Mikrobatterien (Feststoffelektrolytzwischenschichten statt PZT, Batterieaktivmaterialien) und der Kontaktierung von individuellen Lagen von integrierten kleinbauenden Kondensatoren.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (900) zum Herstellen eines Multilagenelektrodensystems (300) mit folgenden Schritten:
Bereitstellen (904) eines Trägersubstrats (100) mit einer Vertiefung (104) in einer Oberseite (102) des Trägersubstrats (100), wobei zumindest eine Wand (106) der Vertiefung (104) in Bezug auf eine der Oberseite (102) gegenüberliegende Unterseite (200) des Trägersubstrats (100) geneigt ausgebildet ist; und
Aufbringen (906) eines Multilagenstapels (302), der zumindest eine erste Elektrodenlage (304), eine zweite Elektrodenlage (306) und eine zwischen der ersten Elektrodenlage (304) und der zweiten Elektrodenlage (306) angeordnete Piezoelektrikumlage (308) aufweist, auf die Oberseite (102) des Trägersubstrats (100), wobei zumindest die Wand (106) und ein Boden (108) der Vertiefung (104) durch zumindest einen Abschnitt des Multilagenstapels (302) abgedeckt werden, um das Multilagenelektrodensystem (300) zu bilden, wobei in dem Schritt des Aufbringens (906) der Multilagenstapel (302) ferner auf einen an die Vertiefung (104) angrenzenden Randbereich der Oberseite (102) des Trägersubstrats (100) aufgebracht wird, **dadurch gekennzeichnet, dass**
der Schritt des Aufbringens (906) einen Teilschritt (906A) des Abtragens des Multilagenstapels (302) bis auf ein Niveau der Oberseite (102) des Trägersubstrats (100) aufweist, um eine mit der Oberseite (102) plane Kontaktierungsfläche (400) zum elektrischen Kontaktieren der ersten Elektrodenlage (304) und der zweiten Elektrodenlage (306) zu bilden.

2. Verfahren gemäß Anspruch 1, **dadurch gekennzeichnet, dass** eine Seitenfläche (500) der ersten Elektrodenlage (304) einen Anschlussbereich für einen ersten Kontakt (602; 800) bereitstellt und eine Seitenfläche (502) der zweiten Elektrodenlage (306) einen Anschlussbereich für einen zweiten Kontakt (602; 802) bereitstellt.

3. Verfahren (900) gemäß Anspruch 2, **dadurch gekennzeichnet, dass** das Verfahren (900) einen Schritt des Passivierens (908) des Multilagenstapels (302) aufweist, wobei in einem ersten Teilschritt des Passivierens (908A) eine Passivierungsschicht (600) auf das Multilagenelektrodensystem (300) aufgebracht wird und in einem zweiten Teilschritt des Passivierens (908B) ein Bereich der Passivierungsschicht (600) so entfernt wird, dass zumindest eine in einem spitzen Winkel (702) zu der Seitenfläche (500) der ersten Elektrodenlage (304) und der Seitenfläche (502) der zweiten Elektrodenlage (306) verlaufende Kontaktbahn (700) gebildet wird, die durch Freilegen eines Abschnitts des Anschlussbereichs für einen ersten Kontakt (602; 800) eine erste Kontaktfläche (708) bildet und durch Freilegen eines Abschnitts des Anschlussbereichs für einen zweiten Kontakt (602; 802) eine zweite Kontaktfläche (710) bildet, insbesondere wobei die zweite Kontaktfläche (710) versetzt zu der ersten Kontaktfläche (708) angeordnet wird.

4. Verfahren (900) gemäß Anspruch 3, **dadurch gekennzeichnet, dass** in dem Schritt des Passivierens (908) die Kontaktbahn (700) so gebildet wird, dass sie sich unter einem spitzen Winkel zu dem Multilagenstapel (302) erstreckt.

5. Verfahren (900) gemäß Anspruch 3 oder 4, **dadurch gekennzeichnet, dass** in dem Schritt des Passivierens (908) zumindest eine innerhalb eines Toleranzbereichs parallel zu der Kontaktbahn (700) verlaufende weitere Kontaktbahn gebildet wird.

6. Verfahren (900) gemäß einem der vorangegangenen Ansprüche 3 bis 5, **dadurch gekennzeichnet, dass** das Verfahren (900) einen Schritt des elektrisch leitfähigen Kontaktierens (910) aufweist, in dem ein erster Kontakt (602; 800) quer zu der Kontaktbahn (700) so auf das Multilagenelektrodensystem (300) aufgesetzt wird, dass er die erste Kontaktfläche (708) elektrisch kontaktiert und ein zweiter Kontakt (602; 802) quer zu der Kontaktbahn (700) so auf das Multilagenelektrodensystem (300) aufgesetzt wird, dass er die zweite Kontaktfläche (710) elektrisch kontaktiert.

7. Verfahren (900) gemäß Anspruch 6, **dadurch gekennzeichnet, dass** in dem Schritt des elektrischen Kontaktierens (910) der erste Kontakt (602; 800) und der zweite Kontakt (602; 802) innerhalb eines Toleranzbereichs senkrecht zu der Kontaktbahn (700) auf das Multilagenelektrodensystem (300) aufgesetzt werden.

8. Verfahren (900) gemäß Anspruch 6 oder 7, **dadurch gekennzeichnet, dass** in dem Schritt des elektrischen Kontaktierens (910) zumindest ein weiterer erster Kontakt (602; 800) und zumindest ein weiterer zweiter Kontakt (602; 802) auf das Multilagenelektrodensystem (300) so aufgesetzt werden, dass der weitere erste Kontakt (602; 800) die erste Kontaktfläche (708) elektrisch kontaktiert und der weitere zweite Kontakt (602; 802) die zweite Kontaktfläche (710) elektrisch kontaktiert.

9. Verfahren (900) gemäß einem der vorangegangenen Ansprüche, **dadurch gekennzeichnet, dass** das Verfahren (900) ferner einen Schritt des Bildens (902) der Vertiefung (104) in der Oberseite (102) des Trägersubstrats (100) aufweist, insbesondere wobei die Vertiefung (104) durch ein strukturiertes Ätzen der Oberseite (102) des Trägersubstrats (100) gebildet wird.

10. Vorrichtung zum Herstellen eines Multilagenelektrodensystems (300), wobei die Vorrichtung die folgenden Merkmale aufweist:
eine Einrichtung zum Bereitstellen (904) eines Trägersubstrats (100) mit einer Vertiefung (104) in einer Oberseite (102) des Trägersubstrats (100), wobei zumindest eine Wand (106) der Vertiefung (104) gegenüber einer der Oberseite (102) gegenüberliegenden Unterseite (200) des Trägersubstrats (100) geneigt ausgebildet ist;
eine Einrichtung zum Aufbringen (906) eines Multilagenstapels (302), der zumindest eine erste Elektrodenlage (304), eine zweite Elektrodenlage (306) und eine zwischen der ersten Elektrodenlage (304) und der zweiten Elektrodenlage (306) angeordnete Piezoelektrikumlage (308) aufweist, auf die Oberseite (102) des Trägersubstrats (100), wobei die Einrichtung ausgebildet ist, um zumindest die Wand (106) und einen Boden (108) der Vertiefung (104) durch zumindest einen Abschnitt des Multilagenstapels (302) abzudecken, um das Multilagenelektrodensystem (300) zu bilden und
eine Einrichtung zum Abtragen des Multilagenstapels (302), der beim Aufbringen (906) der Multilagenstapel (302) ferner auf einen an die Vertiefung (104) angrenzenden Randbereich der Oberseite (102) des Trägersubstrats (100) aufgebracht wird, bis auf ein Niveau der Oberseite (102) des Trägersubstrats (100), um eine mit der Oberseite (102) plane Kontaktierungsfläche (400) zum elektrischen Kontaktieren der ersten Elektrodenlage (304) und der zweiten Elektrodenlage (306) zu bilden.

11. Multilagenelektrodensystem (300), das folgende Merkmale aufweist:
ein Trägersubstrat (100) mit einer Vertiefung (104) in einer Oberseite (102) des Trägersubstrats (100), wobei zumindest eine Wand (106) der Vertiefung (104) in Bezug auf eine der Oberseite (102) gegenüberliegende Unterseite (200) des Trägersubstrats (100) geneigt ausgebildet ist; und
einen Multilagenstapel (302), der zumindest eine erste Elektrodenlage (304), eine zweite Elektrodenlage (306) und eine zwischen der ersten Elektrodenlage (304) und der zweiten Elektrodenlage (306) angeordnete Zwischenlage (308) aufweist, wobei der Multilagenstapel (302) auf der Oberseite (102) des Trägersubstrats (100) angeordnet ist, und wobei zumindest die Wand (106) und ein Boden (108) der Vertiefung (104) durch zumindest einen Abschnitt des Multilagenstapels (302) abgedeckt sind, um das Multilagenelektrodensystem (300) zu bilden, und wobei der Multilagenstapel (302), der beim Aufbringen (906) ferner auf einen an die Vertiefung (104) angrenzenden Randbereich der Oberseite (102) des Trägersubstrats (100) aufgebracht wird, bis auf ein Niveau der Oberseite (102) des Trägersubstrats (100) abgetragen ist, um eine mit der Oberseite (102) plane Kontaktierungsfläche (400) zum elektrischen Kontaktieren der ersten Elektrodenlage (304) und der zweiten Elektrodenlage (306) zu bilden.

12. Multilagenelektrodensystem (300), nach Anspruch 11, **dadurch gekennzeichnet, dass** eine Seitenfläche (500) der ersten Elektrodenlage (304) einen Anschlussbereich für einen ersten Kontakt (602; 800) bereitstellt und eine Seitenfläche (502) der zweiten Elektrodenlage (306) einen Anschlussbereich für einen zweiten Kontakt (602; 802) bereitstellt.

13. Multilagenelektrodensystem (300), nach Anspruch 11 und 12 **dadurch gekennzeichnet, dass** die Zwischenlage (308) eine Piezoelektrikumlage (308) ist.

14. Computer-Programmprodukt mit Programmcode zur Durchführung oder Ansteuerung von Schritten des Verfahrens (900) nach einem der Ansprüche 1 bis 9, wenn das Programmprodukt auf einer Vorrichtung gemäß Anspruch 10 ausgeführt wird.

## Claims

1. Method (900) for producing a multi-layer electrode system (300) having the following steps:
providing (904) a carrier substrate (100) that has a recess (104) in an upper face (102) of the carrier substrate (100), wherein at least one wall (106) of the recess (104) is embodied in an inclined manner with respect to a lower face (200) of the carrier substrate (100), said lower face lying opposite to the upper face (102); and
applying (906) to the upper face (102) of the carrier substrate (100) a multi-layer stack (302) that comprises at least one first electrode layer (304), a second electrode layer (306) and a piezoelectrical layer (308) that is arranged between the first electrode layer (304) and the second electrode layer (306), wherein at least the wall (106) and a base (108) of the recess (104) are covered by at least one section of the multi-layer stack (302) in order to form the multi-layer electrode system (300), wherein in the application step (906) the multi-layer stack (302) is moreover applied to an edge region of the upper face (102) of the carrier substrate (100), said edge region being adjacent to the recess (104), **characterized in that** the application step (906) comprises a part step (906A) of removing the multi-layer stack (302) down to a level of the upper face (102) of the carrier substrate (100) in order to form a planar contacting surface area (400) with the upper face (102) in order to make electrical contact with the first electrode layer (304) and the second electrode layer (306).

2. Method according to Claim 1, **characterized in that** a lateral surface (500) of the first electrode layer (304) provides a connecting region for a first contact (602; 800) and a lateral surface (502) of the second electrode layer (306) provides a connecting region for a second contact (602; 802).

3. Method (900) according to Claim 2, **characterized in that** the method (900) comprises a step of passivation (908) the multi-layer stack (302), wherein a passivation layer (600) is applied to the multi-layer electrode system (300) in a first part step of a passivation process (908A) and a region of the passivation layer (600) is removed in a second part step of the passivation process (908B) in such a manner that at least one contact path (700) is formed that extends at an acute angle (702) with respect to the lateral surface (500) of the first electrode layer (304) and to the lateral surface (502) of the second electrode layer (306), said contact path forms a first contact surface area (708) for a first contact (602; 800) by means of revealing a section of the connecting region and by means of revealing a section of the connecting region forms a second contact surface area (710) for a second contact (602; 802), in particular wherein the second contact surface area (710) is arranged in an offset with respect to the first contact surface area (708).

4. Method (900) according to Claim 3, **characterized in that** in the passivation step (908) the contact path (700) is formed in such a manner that it extends at an acute angle with respect to the multi-layer stack (302).

5. Method (900) according to Claim 3 or 4, **characterized in that** in the passivation step (908) at least one further contact path is formed within a tolerance range in a parallel manner with respect to the contact path (700).

6. Method (900) according to any one of the preceding Claims 3 to 5, **characterized in that** the method (900) comprises a step of producing an electrically conductive contact (910) in which a first contact (602; 800) is placed in a transverse manner with respect to the contact path (700) in such a manner on the multi-layer electrode system (300) that said first contact electrically contacts the first contact surface area (708) and a second contact (602; 802) is placed in a transverse manner with respect to the contact path (700) on the multi-layer electrode system (300) in such a manner that said second contact electrically contacts the second contact surface area (710).

7. Method (900) according to Claim 6, **characterized in that** in the step of providing an electrical contact (910) the first contact (602; 800) and the second contact (602; 802) are placed within a tolerance range in a perpendicular manner with respect to the contact path (700) on the multi-layer electrode system (300).

8. Method (900) according to Claim 6 or 7, **characterized in that** in the step of providing an electrical contact (910) at least a further first contact (602; 800) and at least a further second contact (602; 802) are placed on the multi-layer electrode system (300) in such a manner that the further first contact (602; 800) electrically contacts the first contact surface area (708) and the further second contact (602; 802) electrically contacts the second contact area (710).

9. Method (900) according to any one of the preceding claims, **characterized in that** the method (900) moreover comprises a step of forming (902) the recess (104) in the upper face (102) of the carrier substrate (100), in particular wherein the recess (104) is formed by means of etching a structure in the upper face (102) of the carrier substrate (100).

10. Apparatus for producing a multi-layer electrode system (300), wherein the device comprises the following features:
a device for providing (904) a carrier substrate (100) that has a recess (104) in an upper face (102) of the carrier substrate (100), wherein at least one wall (106) of the recess (104) is embodied in an inclined manner with respect to a lower face (200) of the carrier substrate (100), said lower face lying opposite to the upper face (102);
a device for applying (906) to the upper face (102) of the carrier substrate (100) a multi-layer stack (302) that comprises at least one first electrode layer (304), a second electrode layer (306) and a piezoelectrical layer (308) that is arranged between the first electrode layer (304) and the second electrode layer (306), wherein the device is configured so as to cover at least the wall (106) and a base (108) of the recess (104) by at least one section of the multi-layer stack (302) in order to form the multi-layer electrode system (300) and
a device for removing the multi-layer stack (302), which during the application (906) of the multi-layer stack (302) is moreover applied to an edge region of the upper face (102) of the carrier substrate (100), said edge region being adjacent to the recess (104), down to a level of the upper face (102) of the carrier substrate (100) in order to form a planar contacting surface area (400) with the upper face (102) in order to make electrical contact with the first electrode layer (304) and the second electrode layer (306).

11. Multi-layer electrode system (300) that comprises the following features:
a carrier substrate (100) that comprises a recess (104) in an upper face (102) of the carrier substrate (100), wherein at least one wall (106) of the recess (104) is embodied in an inclined manner with respect to a lower face (200) of the carrier substrate (100), said lower face lying opposite to the upper face (102); and
a multi-layer stack (302) that comprises at least one first electrode layer (304), a second electrode layer (306) and an intermediate layer (308) that is arranged between the first electrode layer (304) and the second electrode layer (306), wherein the multi-layer stack (302) is arranged on the upper face (102) of the carrier substrate (100) and wherein at least the wall (106) and a base (108) of the recess (104) are covered by at least one section of the multi-layer stack (302) in order to form the multi-layer electrode system (300), and wherein the multi-layer stack (302), which during the application (906) is moreover applied to an edge region of the upper face (102) of the carrier substrate (100), said edge region being adjacent to the recess (104), is removed down to a level of the upper face (102) of the carrier substrate (100) in order to form a planar contacting surface area (400) with the upper face (102) in order to make electrical contact with the first electrode layer (304) and the second electrode layer (306).

12. Multi-layer electrode system (300) according to Claim 11, **characterized in that** a lateral surface (500) of the first electrode layer (304) provides a connecting region for a first contact (602; 800) and a lateral surface (502) of the second electrode layer (306) provides a connecting region for a second contact (602; 802).

13. Multi-layer electrode system (300) according to Claim 11 and 12 **characterized in that** the intermediate layer (308) is a piezoelectric layer (308).

14. Computer program product having a program code for performing or controlling steps of the method (900) according to any one of Claims 1 to 9 if the program product is implemented on an apparatus according to Claim 10.

## Revendications

1. Procédé (900) de fabrication d'un système d'électrode multicouche (300), comprenant les étapes qui consistent à :
fournir (904) un substrat de support (100) comportant un creux (104) sur une face supérieure (102) du substrat de support (100), dans lequel au moins une paroi (106) du creux (104) est inclinée par rapport à une face inférieure (200) du substrat de support (100) qui est opposée à la face supérieure (102) ; et
déposer (906) sur la face supérieure (102) du substrat de support (100) une pile multicouche (302) qui comporte au moins une première couche d'électrode (304), une deuxième couche d'électrode (306), et une couche piézoélectrique (308) agencée entre la première couche d'électrode (304) et la deuxième couche d'électrode (306), dans lequel au moins la paroi (106) et un fond (108) du creux (104) sont recouverts par au moins une partie de la pile multicouche (302) afin de former le système d'électrode multicouche (300), dans lequel, lors de l'étape de dépôt (906), la pile multicouche (302) est également déposée sur une zone de bord de la face supérieure (102) du substrat de support (100) qui est adjacente au creux (104), **caractérisé en ce que**
l'étape de dépôt (906) comprend une étape partielle (906A) consistant à enlever la pile multicouche (302) jusqu'à un niveau de la face supérieure (102) du substrat de support (100), afin de former une surface de contact (400) plane avec la face supérieure (102) permettant un contact électrique entre la première couche d'électrode (304) et la deuxième couche d'électrode (306).

2. Procédé selon la revendication 1, **caractérisé en ce qu'**une surface latérale (500) de la première couche d'électrode (304) forme une zone de connexion pour un premier contact (602 ; 800) et **en ce qu'**une surface latérale (502) de la deuxième couche d'électrode (306) forme une zone de connexion pour un deuxième contact (602 ; 802).

3. Procédé (900) selon la revendication 2, **caractérisé en ce que** le procédé (900) comprend une étape consistant de passivation (908) de la pile multicouche (302), dans lequel, lors d'une première étape de passivation partielle (908A), une couche de passivation (600) est déposée sur le système d'électrode multicouche (300) et, lors d'une deuxième étape de passivation partielle (908B), une zone de la couche de passivation (600) est éliminée de manière à former au moins une piste de contact (700) s'étendant en formant un angle aigu (702) par rapport à la surface latérale (500) de la première couche d'électrode (304) et à la surface latérale (502) de la deuxième couche d'électrode (306), laquelle piste de contact forme une première surface de contact (708) par dégagement d'une partie de la zone de connexion pour un premier contact (602 ; 800) et forme une deuxième surface de contact (710) par dégagement d'une partie de la zone de connexion pour un deuxième contact (602 ; 802), en particulier, dans lequel la deuxième surface de contact (710) est agencée de manière décalée par rapport à la première surface de contact (708).

4. Procédé (900) selon la revendication 3, **caractérisé en ce que**, lors de l'étape de passivation (908), la piste de contact (700) est formée de manière à ce qu'elle s'étende en formant un angle aigu par rapport à la pile multicouche (302).

5. Procédé (900) selon la revendication 3 ou 4, **caractérisé en ce que**, lors de l'étape de passivation (908), au moins une autre piste de contact s'étendant à l'intérieur d'une plage de tolérance est formée parallèlement à la piste de contact (700).

6. Procédé (900) selon l'une quelconque des revendications 3 à 5 précédentes, **caractérisé en ce que** le procédé (900) comprend une étape consistant à établir un contact électriquement conducteur (910) en réalisant un premier contact (602 ; 800) transversalement à la piste de contact (700) sur le système d'électrode multicouche (300) de manière à ce qu'il soit mis en contact électrique avec la première surface de contact (708) et en réalisant un deuxième contact (602 ; 802) transversalement à la piste de contact (700) sur le système d'électrode multicouche (300) de manière à ce qu'il soit mis en contact électrique avec la deuxième surface de contact (710).

7. Procédé (900) selon la revendication 6, **caractérisé en ce que**, lors de l'étape de mise en contact électrique (910), le premier contact (602 ; 800) et le deuxième contact (602 ; 802) sont agencés à l'intérieur d'une zone de tolérance perpendiculairement à la piste de contact (700) sur le système d'électrode multicouche (300).

8. Procédé (900) selon la revendication 6 ou 7, **caractérisé en ce que**, lors de l'étape de mise en contact électrique (910), au moins un autre premier contact (602 ; 800) et au moins un autre deuxième contact (602 ; 802) sont réalisés sur le système d'électrode multicouche (300) de manière à ce que l'autre premier contact (602 ; 800) soit mis en contact électrique avec la première surface de contact (708) et à ce que l'autre deuxième contact (602 ; 802) soit mis en contact électrique avec la deuxième surface de contact (710).

9. Procédé (900) selon l'une quelconque des revendications précédentes, **caractérisé en ce que** le procédé (900) comprend en outre une étape consistant à former (902) le creux (104) dans la face supérieure (102) substrat de support (100), en particulier, dans lequel le creux (104) est formé par gravure structurée de la face supérieure (102) du substrat de support (100).

10. Dispositif de fabrication d'un système d'électrode multicouche (300), dans lequel le dispositif comprend :
un moyen destiné à fournir (904) un substrat de support (100) doté d'un creux (104) dans une face supérieure (102) du substrat de support (100), dans lequel au moins une paroi (106) du creux (104) est inclinée par rapport à une face inférieure (200) du substrat de support (100) qui est opposée à la face supérieure (102) ;
un moyen destiné à appliquer (906) une pile multicouche (302), qui comporte au moins une première couche d'électrode (304), une deuxième couche d'électrode (306) et une couche piézoélectrique (308) agencée entre la première couche d'électrode (304) et la deuxième couche d'électrode (306), sur la face supérieure (102) du substrat de support (100), dans lequel le moyen est réalisé de manière à recouvrir au moins la paroi (106) et un fond (108) du creux (104) par au moins une partie de la pile multicouche (302) afin de former le système d'électrode multicouche (300), et
un moyen destiné à enlever la pile multicouche (302) qui est également déposée lors de l'application (906) de la pile multicouche (302) sur une zone de bord de la face supérieure (102) du substrat de support (100) qui est adjacente au creux (104) jusqu'à un niveau de la face supérieure (102) du substrat de support (100) afin de former une surface de mise en contact (400) plane avec la surface supérieure (102) permettant un contact électrique entre la première couche d'électrode (304) et la deuxième couche d'électrode (306).

11. Système d'électrode multicouche (300), comprenant :
un substrat de support (100) doté d'un creux (104) dans une face supérieure (102) du substrat de support (100), dans lequel au moins une paroi (106) du creux (104) est inclinée par rapport à une face inférieure (200) du substrat de support (100) qui est opposée à la face supérieure (102) ; et
une pile multicouche (302), qui comporte au moins une première couche d'électrode (304), une deuxième couche d'électrode (306) et une couche intermédiaire (308) agencée entre la première couche d'électrode (304) et la deuxième couche d'électrode (306), dans lequel la pile multicouche (302) est agencée sur la face supérieure (102) du substrat de support (100), et dans lequel au moins la paroi (106) et un fond (108) du creux (104) sont recouverts par au moins une partie de la pile multicouche (302) afin de former le système d'électrode multicouche (300), et dans lequel la pile multicouche (302) qui est également déposée sur une zone de bord de la face supérieure (102) du substrat de support (100) qui est adjacente au creux (104) lors du dépôt (906), est éliminée jusqu'à un niveau de la face supérieure (102) du substrat de support (100) de manière à former une surface de mise en contact (400) plane avec la face supérieure (102) pour l'établissement d'un contact électrique entre la première couche d'électrode (304) et la deuxième couche d'électrode (306).

12. Système d'électrode multicouche (300) selon la revendication 11, **caractérisé en ce qu'**une surface latérale (500) de la première couche d'électrode (304) fournit une zone de connexion pour un premier contact-(602 ; 800) et **en ce qu'**une surface latérale (502) de la deuxième couche d'électrode (306) fournit une zone de connexion pour un deuxième contact (602 ; 802).

13. Système d'électrode multicouche (300) selon les revendications 11 et 12, **caractérisé en ce que** la couche intermédiaire (308) est une couche piézoélectrique (308).

14. Produit de programme d'ordinateur comportant un code de programme destiné à mettre en oeuvre ou à commander des étapes du procédé (900) selon l'une quelconque des revendications 1 à 9 lorsque le produit de programme est exécuté sur un dispositif selon la revendication 10.
